# EUROPEAN PATENT APPLICATION

(11) **EP 4 465 348 A2**
(43) Date of publication of application: **20.11.2024**
(21) Application number: 24168206.1
(22) Date of filing: 03.04.2024
(51) Int. Cl.: H01L 23/31, H01L 23/498, H01L 23/538, H01L 23/00, H05K 1/18

(54) **SUBSTRATE WITH EMBEDDED ELEMENTS AND MANUFACTURING METHOD OF THE SAME**

(30) Priority: 15.05.2023 US 202363466385 P
(71) Applicant: Absolics Inc., Covington, GA 30014 (US)
(72) Inventor: KIM, Tae Kyoung, Covington, 30014 (US); KIM, Jincheol, 18469 Hwaseong-si, Gyeonggi-do (KR); OH, Jun Rok, 18469 Hwaseong-si, Gyeonggi-do (KR); KIM, Sungjin, Covington, 30014 (US)
(74) Representative: BCKIP Part mbB

(57) **Abstract**

A substrate with an embedded element includes a core substrate (21) having one surface and a cavity (23) recessed from the one surface in a thickness direction; an element package (18) disposed in the cavity, the element package comprising one or more elements (11); and a substrate insulating material (27) surrounding at least part of the element package. When observed from a side surface of the substrate with the embedded element, the substrate with the embedded element includes a cavity area in which the cavity is disposed and a substrate area outside of the cavity area. An absolute value of difference between an average thickness of the substrate area and an average thickness of the cavity area is 50 µm or less.

## Description

This application claims the priority benefit of U.S. Provisional Patent Application No. 63/466,385, filed on May 15, 2023.

### BACKGROUND

### 1. Field

The following description relates to a substrate with embedded elements and a manufacturing method of the same.

### 2. Description of the Background

As the electronic industry develops, electronic products are desired to have high density, multifunctionality, and miniaturization. An element-embedded substrate or package may incorporate a passive or active element into a package substrate. These can shorten the circuit length and improve electrical properties, increase the reliability of the package substrate, and reduce manufacturing costs.

However, when multiple elements are to be embedded in a substrate such as a glass plate, especially when multiple elements are arranged adjacent to each other, a separation between the elements is desired, and it may be difficult to avoid undulation after forming the insulating layer in the entire area of the substrate. If the thickness of the substrate after formation is uneven, there may be a risk of depth deviation during via processing through a laser, etc., and may be hard to form a circuit thereon.

For smooth circuit formation and performance optimization, it is desirable to consider various configuration methods that maintain a constant thickness after forming an insulating layer in the entire area of the device-embedded substrate.

The above information is presented as background information only to assist with an understanding of the present disclosure. No determination has been made, and no assertion is made, as to whether any of the above might be applicable as prior art with regard to the disclosure.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a substrate with an embedded element includes a core substrate having one surface and a cavity recessed from the one surface in a thickness direction; an element package disposed in the cavity, the element package comprising one or more elements; and a substrate insulating material surrounding at least part of the element package. When observed from a side surface of the substrate with the embedded element, the substrate with the embedded element includes a cavity area in which the cavity is disposed and a substrate area outside of the cavity area. An absolute value of difference between an average thickness of the substrate area and an average thickness of the cavity area is 50 µm or less.

The element package may further include an element insulating material surrounding the one or more elements. The element insulating material may include one selected from the group consisting of an epoxy-based resin, a polyimide-based resin, a polyurethane-based resin, a polyester-based resin, an acrylate-based resin, a polyamide-based resin and a combination thereof.

The core substrate may include a glass-based material. The glass-based material may include one selected from the group consisting of borosilicate glass, soda-lime glass, lead glass, aluminosilicate glass, quartz glass and a combination thereof.

A thickness of the core substrate may be 100 µm to 2,000 µm.

The core substrate may further include a core via penetrating the substrate area in the thickness direction.

The core substrate may include a core inner surface surrounding the cavity, and the substrate with embedded the element may further include a conductive layer disposed on the one surface and the core inner surface.

The element package may include two or more elements, and a distance between adjacent elements of the two or more elements may be 30 µm to 300 µm.

The core substrate may include a core inner surface surrounding the cavity. The substrate with the embedded element may have a first point disposed on a surface of an element of the one or more elements and a second point disposed on the core inner surface, and a minimum distance between the first point and the second point may be 20 µm to 150 µm.

A thickness of the element package may be 335 µm to 665 µm.

Observed from a cross-section of an in-plane direction of the substrate with the embedded element, a ratio of a value of an area of the cavity minus an area of the one or more elements based on the area of the cavity may be 2.5% to 15%.

When observed from a cross-section of a thickness direction of the substrate with the embedded element, a ratio of a value of an area of the cavity minus an area of the one or more elements based on the area of the cavity may be 2.5% to 15%.

A ratio of a value of a volume of the cavity minus a volume of the one or more elements based on the volume of the cavity may be 2% to 18%.

In another general aspect, a manufacturing method of a substrate with embedded elements includes preparing a core substrate having one surface and a cavity recessed from the one surface in a thickness direction, and an element package comprising one or more elements; and disposing the element package in the cavity and forming an insulating material to surround at least part of the element package.

The disposing the element package in the cavity and the forming the insulating material may include filling a substrate insulating base material to surround at least part of the element package, and forming the insulating material by curing the insulating base material.

Other features and aspects will be apparent from the following detailed description, the drawings, and the claims.

### BRIEF DESCRIPTION OF THE DRAWINGS

FIG. 1(a) shows an example of an element package according to one embodiment.
FIG. 1(b) shows an example of a core substrate according to one embodiment.
FIG. 2 is a schematic diagram illustrating an example of a substrate with embedded elements according to one embodiment.
FIG. 3 is a schematic diagram illustrating an example of a substrate with embedded elements with a problem.
FIGS. 4(a)-(g) are schematic diagrams illustrating a process of manufacturing a substrate with embedded elements according to one embodiment.
FIG. 5(a) shows another example of an element package according to one embodiment.
FIG. 5(b) shows another example of a core substrate according to one embodiment.

Throughout the drawings and the detailed description, unless otherwise described, the same reference numerals refer to the same elements. The drawings may not be to scale, and the relative size, proportions, and depiction of elements in the drawings may be exaggerated for clarity, illustration, and convenience.

### DETAILED DESCRIPTION

Hereinafter, while examples of the present disclosure will be described in detail with reference to the accompanying drawings, it is noted that examples are not limited to the same.

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of this disclosure. For example, the sequences of operations described herein are merely examples, and are not limited to those set forth herein, but may be changed as will be apparent after an understanding of this disclosure, with the exception of operations necessarily occurring in a certain order. Also, descriptions of features that are known in the art may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of this disclosure.

Throughout the specification, when an element, such as a layer, region, or substrate is described as being "on," "connected to," or "coupled to" another element, it may be directly "on," "connected to," or "coupled to" the other element, or there may be one or more other elements intervening therebetween. In contrast, when an element is described as being "directly on," "directly connected to," or "directly coupled to" another element, there can be no other elements intervening therebetween.

As used herein, the term "and/or" includes any one and any combination of any two or more of the associated listed items; likewise, "at least one of' includes any one and any combination of any two or more of the associated listed items.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

Spatially relative terms, such as "above," "upper," "below," "lower," and the like, may be used herein for ease of description to describe one element's relationship to another element as shown in the figures. Such spatially relative terms are intended to encompass different orientations of the device in use or operation in addition to the orientation depicted in the figures. For example, if the device in the figures is turned over, an element described as being "above," or "upper" relative to another element would then be "below," or "lower" relative to the other element. Thus, the term "above" encompasses both the above and below orientations depending on the spatial orientation of the device. The device may also be oriented in other ways (rotated 90 degrees or at other orientations), and the spatially relative terms used herein are to be interpreted accordingly.

The terminology used herein is for describing various examples only, and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Due to manufacturing techniques and/or tolerances, variations of the shapes shown in the drawings may occur. Thus, the examples described herein are not limited to the specific shapes shown in the drawings, but include changes in shape that occur during manufacturing.

Herein, it is noted that use of the term "may" with respect to an example, for example, as to what an example may include or implement, means that at least one example exists in which such a feature is included or implemented while all examples are not limited thereto.

The features of the examples described herein may be combined in various ways as will be apparent after an understanding of this disclosure. Further, although the examples described herein have a variety of configurations, other configurations are possible as will be apparent after an understanding of this disclosure.

### Substrate with embedded elements 100

In order to achieve the above object, a substrate with embedded elements 100, according to the present disclosure, includes a core substrate 21 including one surface and a cavity 23, which is an inner space formed by recessing from the one surface of the core substrate 21; and an element package 18 disposed in the cavity.

The core substrate 21 may include the one surface and the other surface facing the one surface. The one surface may be an upper surface of the core substrate 21. The other surface may be a lower surface of the core substrate 21.

The element package 18 is the one in which one or more elements 11 are arranged.

The substrate with embedded elements 100 includes a substrate insulating material 27 surrounding at least part of the element package 18. The substrate insulating material 27 may be formed to seal the element package 18.

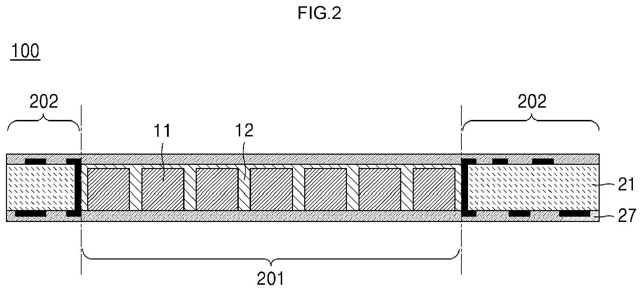

When observed from the one surface side of the substrate with embedded elements 100, the substrate with embedded elements 100 includes a cavity area 201, which is an area where the cavity is disposed, and a substrate area 202, which is an area other than the cavity area. An absolute value of the difference between an average thickness of the substrate with embedded elements 100 measured in the substrate area and an average thickness of the substrate with embedded elements 100 measured in the cavity area is 50 µm or less. The thickness difference (TD) may be a value obtained by subtracting an average thickness of the substrate with embedded elements 100 at a cavity area 201 from an average thickness of the substrate with embedded elements 100 at a substrate area 202. For example, as shown in FIG. 2, it may be an absolute value of the difference between an average thickness in a cavity area and an average thickness in a substrate area in a substrate with embedded elements equipped with a cured substrate insulating material 27 and a conductive layer.

The TD may be 40 µm or less, 30 µm or less, or 20 µm or less. The TD may be 0 µm, more than 0 µm, or 1 µm or more. By the TD in this range, it is possible to have a substrate insulating material layer 27 with uniform thickness throughout the substrate with an embedded element 100, and an additional grinding process for thickness flattening may be minimized or omitted.

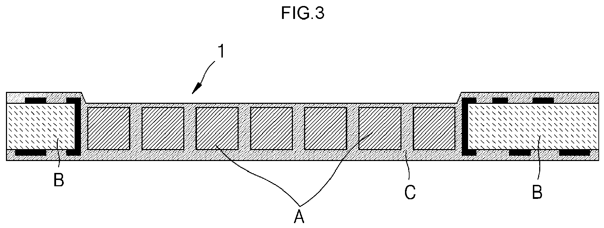

In FIG. 3, an element-embedded substrate 1 obtained by placing elements A in a cavity of a substrate B and filling and molding an insulating material without preparing an element package 18 is illustrated. In this case, there might be a problem that the thickness difference between the area where the elements are disposed with other areas becomes larger, and it may negatively affect substrate reliability and circuit formation. In addition, if each thickness of the arranged elements is different, the empty space increases on the top of the thinnest element, which may make the thickness difference problem even more serious when filling the insulating material.

In order to solve the problem shown in FIG. 3, the present disclosure introduced an element package 18 as shown in FIG. 2, placed an element package 18 in a cavity of a core substrate, and sealed it with a substrate insulating material 27 to minimize a difference in thickness between the area where the elements are placed and other areas.

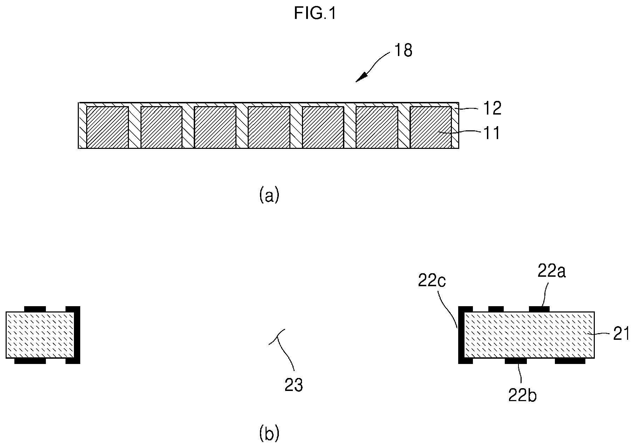

Referring to FIG. 1(a), FIG. 1(b), and FIG. 2, an element package 18 may include one or more elements 11 and an element insulating material 12 surrounding at least part of the element 11. The elements 11 may be arranged in a line in the element insulating material, or a plurality of elements may be arranged in two or more horizontally and vertically predetermined intervals. The element package may be molded with an element-insulating material 12 so that the arranged elements are fixed and insulated.

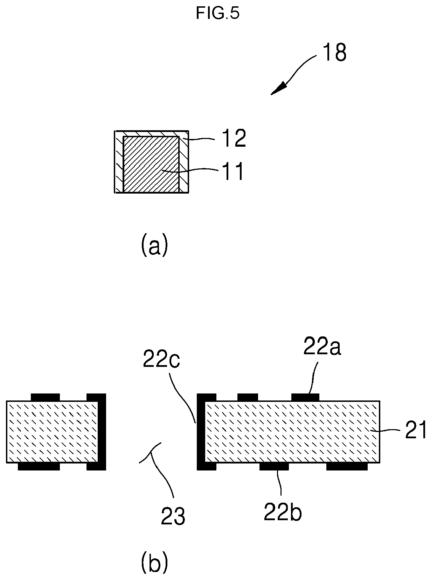

FIG. 5(a) shows that an element package 18 may have one element 11, and FIG. 5(b) shows that a core substrate 21 may accommodate the element 11. Even when only one element is applied, the substrate may satisfy the TD value range when the substrate with embedded elements 100 is formed, and the thickness unevenness problem of the insulating material layer may be minimized.

When there are two or more elements 11 included in an element package 18, a distance between neighboring elements 11 may be 30 µm to 300 µm, 50 µm to 250 µm, or 80 µm to 200 µm.

When there are two or more elements 11 included in an element package 18, an average distance between neighboring elements 11 may be 30 µm to 300 µm, 50 µm to 250 µm, or 80 µm to 200 µm.

By having such an interval, it is possible to minimize the occurrence of interference in a cavity of a core substrate and increase space utilization.

The thickness of an element package 18 may be 335 µm to 665 µm, 370 µm to 620 µm, or 400 µm to 600 µm. The thickness of an element package may be substantially the same as the thickness of a core substrate 21 except for a conductive layer 22. The value of the thickness of the core substrate 21 minus the thickness of the element package 18 may be 1 µm to 30 µm.

The element insulating material 12 may include a material capable of appropriately fixing the element and preventing an occurrence of an electrical short circuit. The element insulating material 21 may include one selected from the group consisting of an epoxy-based resin, a polyimide-based resin, a polyurethane-based resin, a polyester-based resin, an acrylate-based resin, a polyamide-based resin, and a combination thereof. For example, the element insulating material 12 may include an epoxy molding compound (EMC), a glass fiber reinforced epoxy (FR-4), etc. The element insulating material 12 may include other additives, a phenol resin, carbon black, a flame retardant, a filler, and the like. The filler that may be included in the element insulating material may be a particle-type filler. The particle size of the filler may be 1 µm to 20 µm, or 2 µm to 15 µm.

The element insulating material 12 may have a thermal expansion coefficient (ppm/°C) of 10 to 20 at a temperature equal to or less than 100°C. The element insulating material may have a thermal expansion coefficient (ppm/°C) of 40 to 60 at a temperature of 180°C or higher.

The element insulating material 12 may have a bending strength at 25°C of 5 kg/mm² to 25 kg/mm², or 10 kg/mm² to 20 kg/mm².

The element insulating material 12 may have a bending modulus of 25°C of 1,200 kg/mm² to 2,500 kg/mm², or 1,300 kg/mm² to 2,000 kg/mm².

The element insulating material 12 may have a thermal conductivity of 0.3 W/mK to 1.5 W/mK.

Since the element insulating material 12 has such properties, the element may be stably fixed and insulated.

The element insulating material 12 may be formed by spreading and curing a raw material on the elements arranged on an arbitrary element supporting part.

In general, elements such as multilayer ceramic capacitors (MLCCs) may have distortion due to heat treatment when manufactured. As a result, there is a possibility of problems such as changing or moving the location of the element during the finishing process, such as mounting the element on the substrate, and arranging and heat-treating the insulating material. In the case of a substrate with embedded elements 100 being used in the element package 18 to which one or more elements are fixed, it is possible to minimize the problem that the element is unnecessarily moved during a manufacturing process such as a curing process of an insulating material.

The core substrate 21 may include a glass-based material and amorphous silica. The glass-based material may include one selected from the group consisting of borosilicate glass, soda-lime glass, lead glass, aluminosilicate glass, quartz glass, and a combination thereof. The core substrate includes the glass-based material, thereby helping to shorten a circuit length and being advantageous in miniaturization.

The core substrate 21 may have a thickness of 100 µm to 2,000 µm, 200 µm to 1,500 µm, or 250 µm to 750 µm. The thickness of the core substrate is the thickness of only the core substrate before an additional conductive layer is formed and corresponds to the thickness of a substrate area without a cavity 23.

The cavity 23 of the core substrate 21 may be an inner space having a shape of penetrating with a thickness direction. The cavity 23 may be an inner space having a shape of being recessed from a part of the core substrate.

As shown in FIG. 2, the cavity area 201 may be an area where the cavity is disposed based on both edges of the cavity from the front view of the substrate with embedded elements 100.

The core substrate 21 may include a core inner surface (not shown) surrounding the cavity 23. The substrate with embedded elements may have a first point placed on a surface of the element 11 and a second point placed on a surface of the core inner surface.

The second point may be placed on a core inner surface parallel to thickness direction of the core substrate 21. A minimum distance between the first point and the second point may be 20 µm to 150 µm, or 30 µm to 80 µm.

The element 11 may have a side surface facing the core inner surface each other. The distance between the side surface of the element 11 and the core inner surface may be 20 µm to 150 µm, or 30 µm to 80 µm.

The distance between the side surface and the core inner surface is measured as a minimum distance between one point placed on the side surface of the element and the other point placed on the core inner surface.

By having such an interval, the element 11 in the element package 18 may be stably disposed in the cavity.

A thickness of the substrate with embedded elements 100 may be 150 µm to 2,200 µm, 250 µm to 1,800 µm, or 350 µm to 900 µm. The thickness of a substrate with embedded elements may correspond to a thickness in a state including all of a conductive layer 22 and a substrate insulating material 27.

The core substrate 21 may further include a core via (not shown) penetrating in the thickness direction, from one surface to the other surface, of the core substrate in the substrate area 202. The core via may further include a conductive layer on its surface. The conductive layer of the core via may be connected to a conductive layer formed on one or another surface of the core substrate. The core via may be filled with an insulating material together with the conductive layer. The conductive layer of the core via may have a thickness of 2 µm or more, 5 µm or more, 10 µm or more, or 15 µm or more. The conductive layer of the core via may have a thickness of 100 µm or less, or a radius of a cross-section of the core via or less. The conductive layer may include copper and an alloy thereof.

The core via may be a circular core via having a circular cross-section with respect to a direction perpendicular to a thickness direction of the core substrate 21. The cross-section may be a non-circular shape having a predetermined aspect ratio, and the core via may be a non-circular core via. The aspect ratio of the cross-section of the non-circular core via can be 1.2 to 30, or 1.5 to 20. The circular core via may have a cylindrical or conical shape. The core via may include a minimum inner diameter portion that is a region having the narrowest inner diameter.

The core via may be formed by processing a preset region of the core substrate 21. The core via may be formed by etching a plate-shaped glass-based material in a physical and/or chemical manner. For example, after forming a defect on the surface of a substrate containing a glass-based material by a laser or the like, a method of chemically etching, laser etching, or the like may be applied.

One surface and another surface of the core substrate 21 may be substantially parallel to each other and may have a constant thickness as a whole.

Referring to FIG. 1, one surface and another surface of the core substrate 21 may have a conductive layer 22 disposed thereon. One surface of the core substrate may include a one surface conductive layer 22a on one surface, and another surface of that may include another surface conductive layer 22b on the other surface. The inner surface of the cavity 23 of the core substrate 21 may include a cavity conductive layer 22c. The cavity conductive layer may be connected to the one surface conductive layer 22a and/or the other surface conductive layer 22b.

The one surface conductive layer 22a and the other surface conductive layer 22b of the core substrate 21 may have a circuit pattern shape. The circuit pattern may be a conductive layer existing in a preset circuit shape. The width and spacing of the circuit pattern may be 4 µm or less, 3 µm or less, or 0.5 µm or more.

The conductive layer 22 that may be formed on the core substrate 21 may have good adhesion to the core substrate. The adhesive force, according to ASTM D3359, may have a value of 4B or more, or 5B or more.

The substrate insulating material 27 may be formed by stacking and curing an uncured or semi-cured insulating material film on the upper and lower portions of the core substrate 21 on which the element package 18 is disposed. In this case, a pressure-reduced lamination method and the like may be applied, and the insulating material may be embedded in the inner space, such as the core via. Accordingly, a thickness difference TD between the cavity area 201 and the substrate area 202 may be formed to be less than or equal to a predetermined range.

The substrate Insulating material 27 may include a phenol-based compound, a phenol ester, a cyanate ester, a glass fiber prepreg, and the like, together with an epoxy-based compound. The substrate insulating material 27 may include polyimide-based resin, bismaleimide-based resin, resin-coated copper, and the like, and may further include inorganic particles, powder, filler, and the like. For example, an azinomoto build-up film (ABF) may be included, and an epoxy resin GL103, or GY50 of azinomoto may be included.

A thermal expansion coefficient (ppm/°C) of the substrate insulating material 27 at a temperature of 25 °C to 150 °C may be 10 to 70, 10 to 30, or 15 to 25.

A thermal expansion coefficient (ppm/°C) of the substrate insulating material 27 at a temperature greater than 150°C and 240°C or less may be 30 to 190.

The substrate insulating material 27 may have a thermal conductivity of 0.1 Wm/K to 0.85 Wm/K.

The substrate insulating material 27 may have an elastic modulus of 1 gPa to 16 gPa at 23°C.

The substrate insulating material 27 may have a tensile strength of 65 MPa to 220 MPa at 23°C.

The substrate insulating material 27 may have an elongation of 0.3% to 7% at 23°C.

The substrate insulating material 27 may have a dielectric constant at 1 MHz of 2 to 4.5 or 2.8 to 4.

The substrate insulating material 27 may have a dielectric constant at 1 GHz of 1.8 to 4.3 or 2.5 to 3.8.

Due to the substrate insulating material 27 having such characteristics as described, the element package 18 in the core substrate 21 may be effectively sealed and insulated.

The substrate insulating material 27 may further include a filler in the form of particles, and inorganic particles may be applied as a filler. The average diameter of the filler may be 150 nm or less, or 1 nm to 100 nm. Applying a filler of this size makes it possible to help form a microcircuit pattern while maintaining the necessary properties of the insulating material at a certain level.

As shown in FIG. 2 and the like, the substrate with embedded elements 100 introduces an element package 18 in which a plurality of elements 11 are fixed by an additional element insulating material 12 into the cavity 23 of the core substrate 21.

When observed from a cross-section with the in-plane direction of the substrate with embedded elements 100, a ratio of the area of the cavity 23 minus an area of the element 11 based on the area of the cavity 23 may be 2.5% to 15%, or 2.7% to 12%.

When observed from a cross-section with the thickness direction of the substrate with embedded elements 100, a ratio of the area of the cavity 23 minus an area of the element 11 based on the area of the cavity 23 may be 2.5% to 15%, or 2.7% to 12%.

The area of the cavity 23 means an area occupied by cavity 23, which is an inner space before any other component is disposed in the cavity 23.

When the core inner surface in a thickness direction is not formed parallel to the thickness of the core substrate 21 (for example, taper shape, inclined surface, etc.), the area of the cavity 23 observed from the cross-section with in-plane direction of the substrate with embedded elements 100 is measured at cross-section having the one surface of the core substrate 21.

Accordingly, a ratio of a cross-sectional area occupied by the rest of the part other than the element in the cavity 23 may be relatively low, and the space may be more efficiently utilized.

A ratio of the volume of the cavity 23 minus the volume of the element 11 based on the volume of the cavity 23 may be 2% to 18%, or 3% to 15%. Through the above, the volume ratio occupied by the rest of the part other than the element 11 in the cavity 23 may be relatively low, and the space may be more efficiently utilized.

The volume of the cavity 23 means a volume of the cavity 23, which is an inner space before any other component is disposed in the cavity 23.

The volume of the substrate with embedded elements in the cavity area may correspond to a cross-sectional area of the substrate with embedded elements in the cavity area multiplied by an average thickness of the substrate with embedded elements in the cavity area.

In the substrate with embedded elements 100 in the cavity area 201, the rest other than the element 11 may substantially correspond to a gap between elements, a gap between the element and the substrate area 200, and an insulating material filled in the gap.

Furthermore, the substrate with embedded elements 100 satisfies the cross-sectional area and volume ratio occupied by the rest of the element 11, thereby minimizing the TD difference between the cavity area 201 and the substrate area 202 when the substrate insulating material (27) is finished and minimizing the occurrence of a problem in which circuit formation is limited. In addition, it is possible to minimize deformation, damage, and movement of elements due to additives or heat treatment during the manufacturing process.

The substrate with embedded elements 100 may serve as an intermediary between the semiconductor element and the main board.

The substrate with embedded elements 100 may further include a connection part (not shown) on one surface or another surface thereof, and thus may be connected to a main board or the like. The connection part may be in the form of a solder ball.

### Manufacturing Method of a Substrate with embedded elements 100

In order to achieve the above object, a manufacturing method of a substrate 100 with embedded elements according to the present disclosure may include a step of preparing a core substrate comprising one surface and a cavity, which is formed by recessing from the one surface of the core substrate with a thickness direction and an element package in which one or more elements are disposed; and a step of disposing the element package in the cavity and forming an insulating material surrounding at least part of the element package.

The step of disposing the element package in the cavity and forming an insulating material surrounding at least part of the element package may include an operation of filling a substrate insulating base material to surround at least part of the element package, and an operation of forming the insulating material 27 by curing the insulating base material.

The method of manufacturing a substrate with embedded elements 100 may not include an additional processing process of flattening the thickness of the insulating material after forming the substrate insulating material 27 and may be performed by the operations.

The step of preparing the core substrate 21 and the element package 18 may include an operation of manufacturing the element package 18.

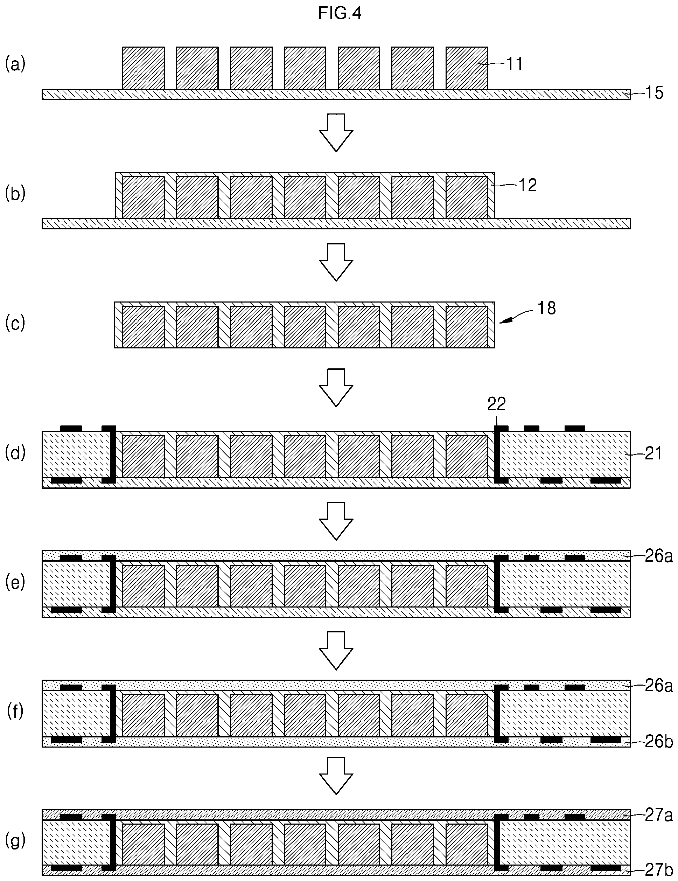

Referring to FIGS. 4(a)-(c), an operation of manufacturing an element package 18 may include a sub-operation of arranging one or more elements 11 on an element supporting part 15, as shown in FIG. 4(a). FIG. 4(b) is a sub-operation of applying and curing an element insulating material to the upper, sides, and spacing of the arranged elements. FIG. 4(c) is a sub-operation of manufacturing the element package by removing the element supporting part after curing.

In the sub-operation of arranging the elements 11, the elements may be arranged in a line at predetermined intervals, and the intervals may be substantially the same as described above.

In the sub-operation of curing, the insulating material may be injected into a mold disposed to surround the elements with a predetermined distance therebetween.

In the operation of manufacturing an element package 18, the edge sides of the element package 18 may be processed to be equal to the size of the cavity 23 of the core substrate 21 to be disposed, or the difference may be minimized. The core substrate 21 may include a glass-based material as described above, and an additional core via (not shown) may be further formed in the substrate area 202. A groove may be formed at a predetermined position of one surface and the other surface of the core substrate 21, and a core via physical or chemical etching may be formed at the part. Thereafter, it may include operations of forming a conductive layer in the upper, lower, and cavity 23 of the core substrate 21, and the conductive layer may include copper and an alloy thereof. The conductive layer may be formed as a circuit pattern by etching in a predetermined pattern.

In the operation of preparing the core substrate 21, when the cavity 23 penetrates the core substrate 21, a core substrate support part may be attached to the lower portion and the other surface of the core substrate 21 to form a seating surface in the cavity. When the cavity 23 has a recessed shape formed by recessing a part of the core substrate 21, not penetrating the core substrate, a sub-operation of attaching the core substrate support part and a sub-operation of removing the same may be omitted.

In the operation of arranging the element package, the element package 18 may be inserted into the cavity 23, as shown in FIG. 4(d). When the core substrate support part is formed on the lower portion and the other surface of the core substrate 21, the element package 18 may be inserted into the seating surface in the cavity 23. In this case, when the size of the element package 18 is larger than the size of the cavity 23, a polishing process of polishing the edge of the element package 18 may be included.

The operation of filling and curing the substrate insulating material may include a sub-operation of filling, depressurizing, and curing an upper portion and a lower portion of the core substrate into which the element package 18 is inserted. As shown in FIG. 4(e) to FIG. 4(g), when the cavity 23 penetrating the core substrate 21 is formed, the substrate insulating material may be first filled on the upper part of the core substrate 21, and then the core substrate support part may be removed, and the insulating material may be filled on the lower part of the core substrate 21. When the cavity 23 is in the form of an inner space in which a groove is recessed from one surface or another surface without penetrating the core substrate 21, the substrate insulating material may be filled on the surface where the cavity 23 is formed. Thereafter, a pressure-sensitive lamination method and the like can be applied, and the insulating material may be embedded in the inner space, such as the core via. In this case, a thickness difference TD between the cavity area 201 and the substrate area 202 may be formed to be less than or equal to a predetermined range.

In the operation of filling and curing the substrate insulating material, the curing may be performed at a temperature of 170°C to 220°C for 30 minutes to 250 minutes.

The manufacturing of element package 18 may be performed after the preparation of the core substrate.

According to the present disclosure, the substrate with embedded elements can form a microcircuit smoothly with a small difference in thickness between the cavity area and other substrate areas by placing an additional element package in the cavity of the core substrate and sealing the element package with a substrate insulating material. In addition, it is possible to minimize deformation, damage, and movement of the element due to additives or heat treatment and the like during the manufacturing process of the substrate with embedded elements.

While specific examples have been shown and described above, it will be apparent after an understanding of this disclosure that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims and their equivalents, and all variations within the scope of the claims and their equivalents are to be construed as being included in the disclosure.

## Claims

1. A substrate with an embedded element, comprising:
a core substrate having one surface and a cavity recessed from the one surface in a thickness direction;
an element package disposed in the cavity, the element package comprising one or more elements; and
a substrate insulating material surrounding at least part of the element package,
wherein when observed from a side surface of the substrate with the embedded element, the substrate with the embedded element comprises a cavity area in which the cavity is disposed and a substrate area outside of the cavity area, and
wherein an absolute value of difference between an average thickness of the substrate area and an average thickness of the cavity area is 50 µm or less.

2. The substrate with the embedded element of claim 1,
wherein the element package further comprises an element insulating material surrounding the one or more elements, and
wherein the element insulating material comprises one selected from the group consisting of an epoxy-based resin, a polyimide-based resin, a polyurethane-based resin, a polyester-based resin, an acrylate-based resin, a polyamide-based resin and a combination thereof.

3. The substrate with the embedded element of claim 1,
wherein the core substrate comprises a glass-based material, and
wherein the glass-based material comprises one selected from the group consisting of borosilicate glass, soda-lime glass, lead glass, aluminosilicate glass, quartz glass and a combination thereof.

4. The substrate with the embedded element of claim 1,
wherein a thickness of the core substrate is 100 µm to 2,000 µm.

5. The substrate with the embedded element of claim 1,
wherein the core substrate further comprises a core via penetrating the substrate area in the thickness direction.

6. The substrate with the embedded element of claim 1,
wherein the core substrate comprises a core inner surface surrounding the cavity, and
wherein the substrate with embedded the element further comprises a conductive layer disposed on the one surface and the core inner surface.

7. The substrate with the embedded element of claim 1,
wherein the element package comprises two or more elements, and a distance between adjacent elements of the two or more elements is 30 µm to 300 µm.

8. The substrate with the embedded element of claim 1,
wherein the core substrate comprises a core inner surface surrounding the cavity,
wherein the substrate with the embedded element has a first point disposed on a surface of an element of the one or more elements and a second point disposed on the core inner surface, and
wherein a minimum distance between the first point and the second point is 20 µm to 150 µm.

9. The substrate with the embedded element of claim 1,
wherein a thickness of the element package is 335 µm to 665 µm.

10. The substrate with the embedded element of claim 1,
wherein when observed from a cross-section of an in-plane direction of the substrate with the embedded element, a ratio of a value of an area of the cavity minus an area of the one or more elements based on the area of the cavity is 2.5% to 15%.

11. The substrate with the embedded element of claim 1,
wherein when observed from a cross-section of a thickness direction of the substrate with the embedded element, a ratio of a value of an area of the cavity minus an area of the one or more elements based on the area of the cavity is 2.5% to 15%.

12. The substrate with the embedded element of claim 1,
wherein a ratio of a value of a volume of the cavity minus a volume of the one or more elements based on the volume of the cavity is 2% to 18%.

13. A manufacturing method of a substrate with embedded elements, comprising:
preparing a core substrate having one surface and a cavity recessed from the one surface in a thickness direction, and an element package comprising one or more elements; and
disposing the element package in the cavity and forming an insulating material to surround at least part of the element package.

14. The manufacturing method of claim 13,
wherein the disposing the element package in the cavity and the forming the insulating material comprises:
filling a substrate insulating base material to surround at least part of the element package, and
forming the insulating material by curing the insulating base material.
